Europäisches Patentamt

European Patent Office

Office européen des brevets

(11) Veröffentlichungsnummer: **0 310 769 B1**

# EUROPÄISCHE PATENTSCHRIFT

(45) Veröffentlichungstag der Patentschrift: **18.08.93**

(21) Anmeldenummer: **88111986.1**

(22) Anmeldetag: **26.07.88**

(51) Int. Cl.5: **G11B 20/02**, H03M 1/12, H03G 7/00

(54) **Verfahren und Anordnung zur Verarbeitung von Signalen, die von einem Speichermedium mit (dynamik-)komprimiert aufgezeichneten Analog(Ton-) Signalen abgetastet werden.**

(30) Priorität: **06.10.87 DE 3733738**
**04.05.88 DE 3815079**

(43) Veröffentlichungstag der Anmeldung:
**12.04.89 Patentblatt 89/15**

(45) Bekanntmachung des Hinweises auf die
Patenterteilung:
**18.08.93 Patentblatt 93/33**

(84) Benannte Vertragsstaaten:
**DE GB**

(56) Entgegenhaltungen:
**EP-A- 0 118 144**
**GB-A- 2 179 810**
**US-A- 3 872 503**

**JOURNAL OF THE AUDIO ENGINEERING SO-
CIETY, Bd. 32, Nr. 5, Mai 1984, NEW YORK US
Seiten 316 - 327; G. W. MCNALLY: 'Dynamic
Range Control of Audio Signals'**

**AUDIO ENGINEERING SOCIETY (AES) PRE-
PRINT OF THE 79TH CONVENTION 1985, 12.
Oktober 1985, New York, Seiten 1-10; J. WER-
MUTH ET AL.: "Design and Application of a
New Compact Compander Card"**

(73) Patentinhaber: **PEICOM sound systems GmbH**
**Gartenstrasse 23-27**
**D-61352 Bad Homburg(DE)**

(72) Erfinder: **Wermuth, Jürgen**
**Drosselweg 1**
**D-3510 Peine(DE)**
Erfinder: **Göckler, Heinz, Dipl.-Ing.**
**Elbinger Strasse 52**
**D-7150 Backnang(DE)**

(74) Vertreter: **Roshardt, Werner Alfred et al**
**Dr. R. Keller + Partner Patentanwälte Marktgasse 31 Postfach**
**CH-3000 Bern 7 (CH)**

EP 0 310 769 B1

## Beschreibung

Verfahren und Anordnung zur Verarbeitung von Signalen, die von einem Speichermedium mit (dynamik-)komprimiert aufgezeichneten Analog-(Ton-)Signalen abgetastet werden.

Die Erfindung betrifft ein Verfahren und eine Anordnung zur Verarbeitung von Signalen, die von einem Speichermedium mit (dynamik-)komprimiert aufgezeichneten Analog(Ton-)Signalen abgetastet werden, um entweder digital oder analog übertragen, weiterbearbeitet und/oder wieder aufgezeichnet zu werden.

In der Vergangenheit sind insbesondere Tonkonserven zur Unterdrückung von Rauschen häufig komprimiert analog aufgezeichnet worden. Um eine natürliche Wiedergabe zu erreichen, wurden die zur Tonkonservierung benutzten Speichermedien anschließend unter Zuhilfenahme eines Expanders abgetastet.

Nachdem sich immer mehr die Digitaltechnik durchsetzt, besteht häufig die Notwendigkeit, Signale, die von Speichermedien mit komprimiert aufgezeichneten Analogsignalen abgetastet werden, in Digitalsignale umzusetzen. Dabei ist es letztlich das Ziel, eine natürliche Wiedergabe mit möglichst wenig Rauschen, also mit einer hohen Dynamik zu erzielen.

Es ist dementsprechend Aufgabe der Erfindung, einen großen Dynamikumfang zu erreichen bei der Umwandlung von komprimiert aufgezeichneten Signalen in digitale Signale zur nachfolgenden Übertragung, Weiterverarbeitung und/oder Aufzeichnung, wobei die Übertragung zu einem Wiedergabegerät erfolgen kann.

Diese Aufgabe wird gelöst durch das Verfahren mit den Merkmalen des Patentanspruches 1 bzw. durch die Anordnung mit den Merkmalen des Patentanspruches 2. Vorteilhafte Weiterbildungen der Anordnung sind in den Unteransprüchen angegeben.

Der Erfindung liegen folgende Uberlegungen zugrunde: An sich wäre es naheliegend, die vom Speichermedium abgetasteten, komprimierten Analogsignale zunächst wieder analog zu expandieren, weil für diesen Zweck die geeigneten analogen Expander zur Verfügung stehen. Es ergäbe sich dann ein expandiertes Analogsignal mit hoher Dynamik. Es hat sich nun aber gezeigt, daß ein nachfolgender Analog/Digital-Wandler in vielen Fällen die hohe Dynamik des Expander-Ausgangssignals wieder beschränken würde, so daß ein unerwünschter Dynamikverlust eintritt.

Mit der Erfindung wird dagegen ein zunächst umständlich erscheinender Weg eingeschlagen, indem das abgetastete komprimierte Analogsignal zuerst einem Analog/Digital-Wandler zugeführt wird. Da das abgetastete, komprimierte Analogsignal einen relativ geringen Dynamikumfang hat, wird bei der Analog/Digital-Wandlung in der Regel keine Einschränkung des Dynamikumfanges stattfinden. Anschließend wird erst eine digitale Expandierung vorgenommen, welche die vorangegangene Komprimierung rückgängig macht. Es entsteht dann ein expandiertes Digitalsignal hohen Dynamikumfanges.

Für dieses Verfahren ist ein digitaler Expander einzusetzen, der diejenige Kompressorfunktion, die bei der vorangegangenen analogen Komprimierung benutzt worden ist, sowohl statisch als auch dynamisch einwandfrei wieder rückgängig macht, der also einen geeigneten analogen Expander in Digitaltechnik nachbildet.

In den Literaturstellen |1|,|2| und |3| sind zwei verschiedene Prinzipien eines vollanalogen Kompandersystems beschrieben, das jeweils aus einem analogen Kompressor und dem dazu passenden analogen Expander besteht. Dabei sind verschiedene Varianten angegeben.

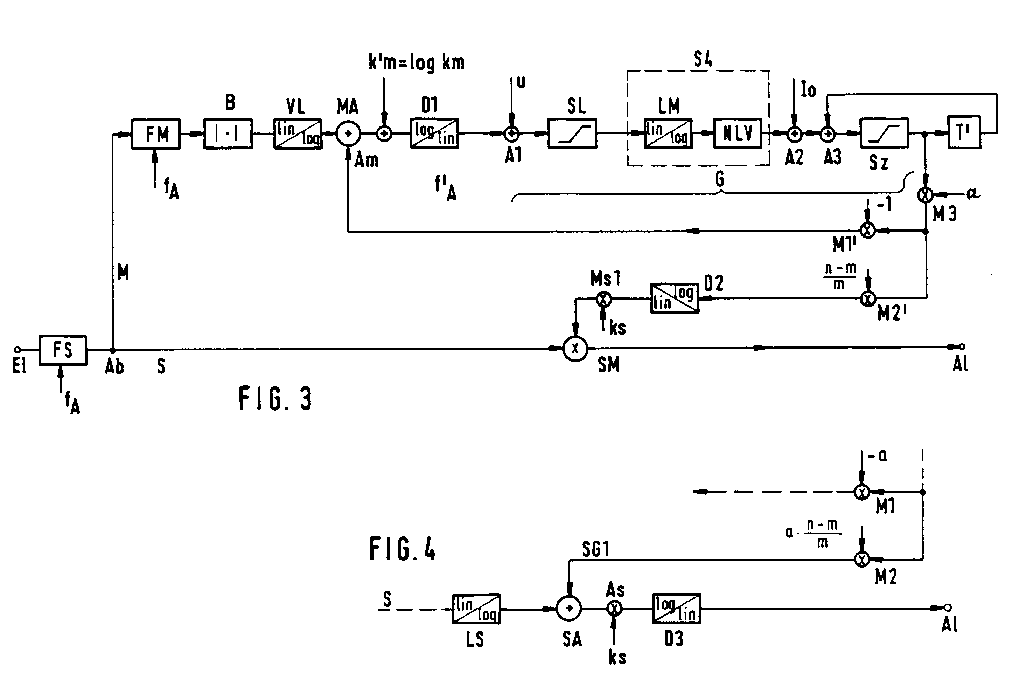

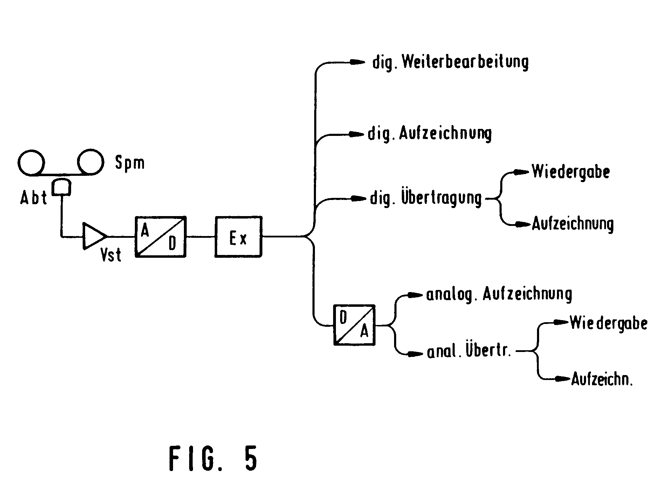

Das Grundprinzip des in Digitaltechnik nachzubildenden analogen Expanders ist in |1|, Abschnitt 3 (3.2) und Abschnitt 4 beschrieben. Eine neuere Version ist |3| (Fig. 5) zu entnehmen. Ferner wird zwischen einer professionellen Version für Studioanwendungen und einer vereinfachten Version für Konsumanwendungen unterschieden (|1| und |2|, Fig. 3). Bei der professionellen Version wird der Nutzspektralbereich (0 ... 20 kHz) in L Teilbänder unterteilt mit Hilfe von Filtern (|2|, |3| : L = 4), wobei für jedes Teilband ein eigener Expander vorgesehen ist (siehe |2|, Abschnitt 5).

Im statischen Fall weist die Verstärkungskennlinie V = P2 - P1 (in dB) in Abhängigkeit vom Eingangspegel P1 eines analogen Kompressors (mit P2 = Ausgangspegel) die Steigung m/n auf, wobei m und n ganze natürliche Zahlen sind. (In |1| bis |3| ist m = 2 und n = 3). Die Verstärkungskennlinie des Expanders muß demnach die Steigung n/m aufweisen, damit sich beide Funktionen im statischen Fall zu einer Gesamtsteigung (m/n) · (n/m) = 1 ergänzen. Digitale konverter des Dynamikbereichs sind aus |5| an sich bekannt.

Im Patentanspruch 3 ist eine Anordnung für den digitalen Expander angegeben, die mit den (teilweise von der Digitaltechnik abweichenden) Möglichkeiten der digitalen Signalverarbeitung kompatibel zu existierenden analogen Kompressoren arbeitet, also bereits existierende analoge Expander systemkompatibel nachbildet.

Anhand der Zeichnungen werden vorteilhafte Ausführungsbeispiele der Erfindung erläutert.
Fig. 1 zeigt ein Blockschaltbild eines bevorzugten Ausführungsbeispieles und die
Figuren 2 bis 4 stellen Varianten dazu dar.

In Figur 5 ist der prinzipielle Aufbau eines Anordnung nach der Erfindung dargestellt.

Sie arbeitet nach folgendem Verfahren:

Von einem Speichermedium Spm (beispielsweise einem Magnetband) mit komprimiert aufgezeichneten Signalen, insbesondere Tonsignalen (denn bei Fernsehsignalen gibt es keine Dynamikprobleme durch A/D-Wandlung), wird mit Hilfe einer Abtasteinrichtung Abt, beispielsweise eines Magnetkopfes, ein komprimiertes Analogsignal abgetastet und einem Verstärker Vst zugeführt, von wo es zu einem Analog/Digital-Wandler A/D gelangt. Diesem ist ein digitaler Expander Ex nachgeschaltet, von welchem die inzwischen digitalen Signale entweder zur digitalen Aufzeichnung oder zur digitalen Übertragung mit anschließender Wiedergabe oder Aufzeichnung oder zu einem D/A-Wandler gelangen, von wo aus sie weitergeleitet werden entweder zur analogen Aufzeichnung oder zur Übertragung, die wiederum entweder eine Wiedergabe oder Aufzeichnung folgt.

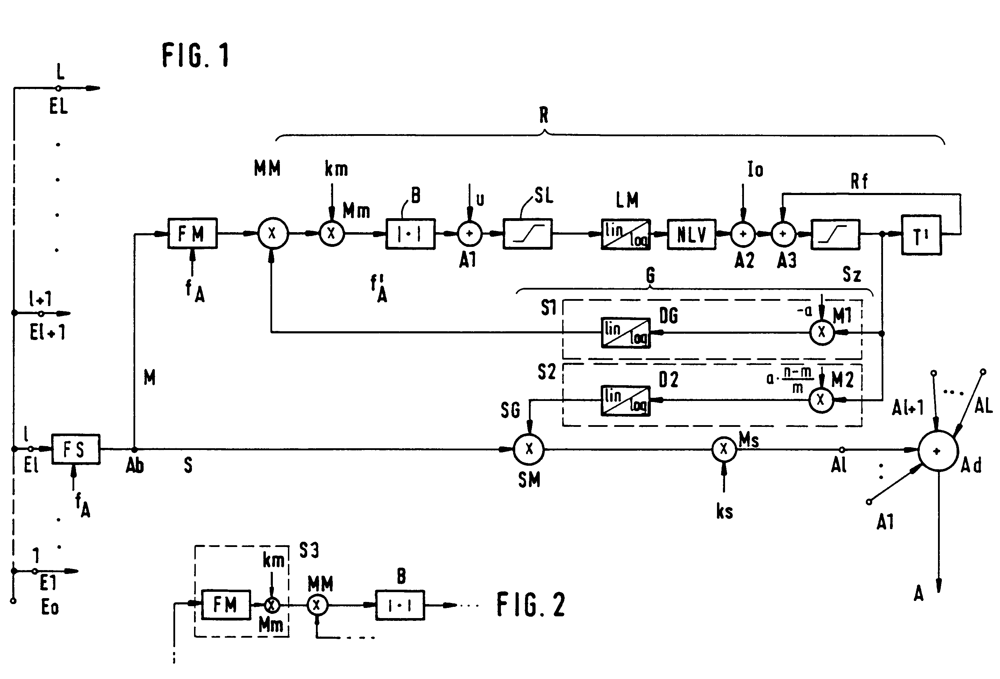

Das in Figur 1 wiedergegebene Blockschaltbild bezieht sich auf einen nach Anspruch 3 ausgeführten digitalen Expander, der kompatibel zu dem in |2| beschriebenen Kompandersystem ist. Von einer Eingangsklemme Eo zweigen Zweige 1, ..., l, l+1, ..., L ab, deren Eingänge mit E1, ..., El, El+1, ..., EL bezeichnet sind. Die Zweige, von denen nur der Zweig l im Detail dargestellt ist, weisen alle die prinzipiell gleiche Struktur auf, unterscheiden sich aber im allgemeinen durch verschiedene Parameter, die vor allem das jeweilige dynamische Verhalten bestimmen. Außerdem sind die an den Eingängen vorgesehen Filter FS, FM zur Aufteilung von Teilfrequenzbändern auf die unterschiedlichen Zweige unterschiedlich.

Jeder Zweig teilt sich an einem Abzweig Ab auf in einen Signalpfad S und einen Meßpfad M. Im Signalpfad S wird zunächst mit dem Filter FS, das wie der ganze Signalpfad mit der Abtastfrequenz $f_A$ arbeitet, die Zweigsignaltrennung vorgenommen. Mit einem als Stellglied arbeitenden Signalpfadmultiplizierer SM wird das zu expandierende Signal bewertet (verstärkt, abgeschwächt etc.) und zwar mit Hilfe der Stellgröße SG, die hier in den zweiten Eingang des Signalpfadmultiplizierers SM aus dem Meßpfad M mündet und letztlich aus dem Signal vom Eingang El abgeleitet ist. Eine weitere Multiplikation mit einer Konstanten ks in einem Abgleichmultiplizierer Ms dient Abgleichzwecken. Schließlich werden alle Zweigsignale, also alle Signale an den Expanderausgängen A1, ..., Al, Al+1, ..., AL mittels eines digitalen Addierers Ad aufsummiert zur Bildung des digital expandierten Gesamtsignales am Ausgang A.

Im Meßpfad M erfolgt hinter dem Abzweig Ab eine weitere Bandbegrenzung im Filter FM. Dessen Ausgangssignal speist einen der Eingänge eines Meßpfadmultiplizierers MM, der in einem Regelkreis liegt. Zu Abgleichzwecken wird das Ausgangssignal des Meßpfadmultiplizierers MM mit einer Konstanten km in einem Abgleichmultiplizierer Mm bewertet. Es folgt eine Betragsbildungsoperation (Unterdrückung des Vorzeichens) in einem Betragsbilder B, danach in einem Addierer A1 die Addition einer Korrekturkonstanten u. Weiterhin ist innerhalb der Regelstrecke R ein Amplitudenbegrenzer Sl vorgesehen, dem ein Logarithmierer LM folgt. Durch den Übergang von der linearen in die logarithmische Wertedarstellung (lin/log) wird erreicht, daß die Expanderkennlinie im logarithmischen Bereich linear ist ("dB-linear", vgl. Bild 3 in |1|). Die erste Operation im logarithmischen Wertebereich ist eine pegelabhängige Verstärkung in einem nichtlinearen Übertragungsglied NLV. Danach folgt ein Addierer A2 zur Addition einer Größe lo und schließlich ein Integrierer, der in einer Integrierer-Regelstrecke einen Amplitudenbegrenzer Sz und in einer Rückführung Rf zu einem Addierer A3 ein Verzögerungsglied T′ aufweist. Geschlossen wird der Regelkreis mit der Regelstrecke R durch eine Gegenkopplungsrückführung G, in der das Ausgangssignal des Integrierers mit -a bewertet oder gewichtet wird. Als Gewichtungsmittel M1 dient wieder ein Multiplizierer. Diesem folgt ein Delogarithmierer DG, durch welchen die Signale wieder in den linearen Wertebereich zurücktransformiert werden (log/lin-Wandlung), also entsprechend der inversen Operation zur linear/logarithmischen Wandlung in dem Logarithmierer LM. Die Ausgangssignale des Delogarithmierers DG dienen innerhalb des Regelkreises im Meßpfad als Stellgröße, werden also dem Meßpfadmultiplizierer MM zugeführt, wodurch die Regelschleife geschlossen ist.

Aus dem Ausgangssignal des Integrierers und damit des Regelkreises wird außerdem die Stellgröße SG für den Signalpfad S abgeleitet durch Bewertung mit a(n-m)/m in einem Gewichtungsmittel M2 mit nachfolgender Delogarithmierung in einem Delogarithmierer D2, der demjenigen in der Gegenkopplungsrückführung G des Regelkreises im Meßpfad M entspricht. Die Parameter n und m bestimmen das statische Verhalten, also die Steilheit n/m der Verstärkungskennlinie des digitalen Expanders. Mit der Wahl des Parameters a kann das dynamische Verhalten des digitalen Expanders festgelegt werden.

Das Eingangs- und das Ausgangssignal des digitalen Expanders sind mit der Abtastfrequenz $f_A$ = 1/T abgetastet. Mit dieser Abtastfrequenz arbeiten auch die Filter FS und FM. Das gleiche kann auch für den Regelkreis mit der Regelstrecke R gelten. Dann ist dessen Abtastfrequenz $f_A′$ = $f_A$ Werden erhöhte Anforderungen an die Nachbildung des analogen Expanders gestellt, so ist $f_A′$ = 1/T′ > $f_A$ zu wählen, wobei T′ die Verzögerungszeit in der Rückführung des Integrierers ist. Die Berechnung der Stellgröße SG im Delogarithmierer D2 kann aber in allen Fällen mit der Abtastfrequenz $f_A$ erfolgen.

Die Anordnung arbeitet so, daß bei konstantem Eingangspegel am Eingang EI am Ausgang der Regelstrecke R ein von Abtastwert zu Abtastwert konstant bleibendes Signal entsteht, also auch die Stellgröße SG konstant bleibt Allerdings sind diese Signale pegelabhängig, so daß durch den Signalpfadmultiplizierer SM größere Signalpegel im Signalpfad S stärker angehoben werden als kleinere Signalpegel (oder kleinere Signalpegel stärker abgesenkt werden als größere), was ja der Sinn eines Expanders ist Bei Pegelaufwärts- oder -abwärtssprüngen am Eingang EI müssen sich am Ausgang der Regelstrecke R bestimmte Übergangsverhaltensweisen zeigen, damit in dem Signalpfadknoten, der durch den Signalpfadmultiplizierer SM gebildet ist, wieder das gewünschte ursprüngliche Signal entsteht, wie es vor der Kompression vorhanden war. Dabei muß berücksichtigt werden, welches Übergangsverhalten der Kompressor hatte, der das Eingangssignal erzeugt hat, das nun analog/digital-gewandelt am Eingang Eo vorliegt. Dieses Übergangsverhalten des Kompressors ist in der Regel unterschiedlich, abhängig davon, ob es sich um einen Aufwärts- oder Abwärts-Pegelsprung handelt. Bei Aufwärtssprüngen ist die Übergangszeit sehr kurz (Millisekundenbereich) und beim Abwärtssprung relativ lang (Sekundenbereich). Damit der in Figur 1 gezeigte Expander ein dynamisches Verhalten zeigt, das an das Verhalten des zugehörigen Kompressors angepaßt ist, ist in der Regelstrecke unter anderem das nichtlineare Übertragungsglied NLV vorgesehen, das eine pegelabhängige Verstärkung im logarithmischen Wertebereich bewirkt. Diese bestimmt zusammen mit dem nachgeschalteten Integrierer das dynamische Verhalten des Expanders bei Aufwärtssprüngen des Pegels. Für das dynamische Verhalten bei Abwärtssprüngen, also für das sogenannte Ausschwingen sorgt vornehmlich die Konstante Io, die dem Addierer A2 zugeführt wird.

Für die kompatible Anwendung des gezeigten Expanders zu dem in |2| beschriebenen System wird m = 2 und n = 3 gewählt. Für die Realisierung der Logarithmierer und Delogarithmierer gibt es zwei Möglichkeiten: Entweder erfolgt eine näherungsweise Berechnung der Ausgangssignale in Abhängigkeit von den Eingangssignalen auf der Grundlage einer Reihenentwicklung oder die Ausgangssignale werden auf der Grundlage einer eingespeicherten Tabelle den Eingangssignalen zugeordnet.

Entsprechendes gilt für das nichtlineare Übertragungsglied NLV: Entweder werden die Ausgangssignale aufgrund einer vorgegebenen mathematischen Funktion in Abhängigkeit von den Eingangssignalen berechnet oder es erfolgt auch hier die Zuordnung der Ausgangssignale zu den Eingangssignalen auf der Grundlage einer eingespeicherten Tabelle. Die Logarithmierer und Delogarithmierer können funktionell mit den jeweils benachbarten Baugruppen zusammengefaßt werden, wie durch die Blöcke S1, S2 in Figur 1 und S4 in Figur 3 angedeutet.

Das Filter FS und/oder FM kann aus kaskadierten oder parallelgeschalteten Teilfiltern bestehen. Es kann als digitales Rekursiv-Filter in kanonischer Struktur (vgl. |4|, Bild 2) oder in Zustandsraumstruktur (vgl. deutsche Patentanmeldungen 35 22 411, 35 22 412, 35 22 413 und 34 39 977) ausgeführt sein.

Die Multiplikation mit der Konstanten km im Abgleichmultiplizierer Mm kann auch vor dem Meßpfadmultiplizierer MM erfolgen, wie in Figur 2 dargestellt. Wenn das Filter FM als Zustandsraumstruktur realisiert ist, wird eine Zusammenfassung S3 dieses Filters mit dem Abgleichmultiplizierer Mm möglich. Dabei werden die Filterkoeffizienten mit der Größe km zusammengefaßt.

Auch der Abgleichmultiplizierer Ms läßt sich über den Signalpfadmultiplizierer SM in den Meßpfad M hineinverschieben (vgl MS1 in Figur 3). Es ergeben sich dadurch verbesserte Rauscheigenschaften des Signalpfades S.

In Figur 3 sind weitere Variationsmöglichkeiten angedeutet: Statt der Gewichtungsmittel (Multiplizierer) M1, M2 in Figur 1 sind in Figur 3 drei Multiplizierer M1', M2' und M3 vorgesehen. Die Wirkung ist ersichtlicherweise dieselbe. Zusätzlich ist der Delogarithmierer DG in Figur 1 in der Gegenkopplungsrückführung G fortgelassen, d.h. dem Meßpfadmultiplizierer MM werden nun Signale im logarithmischen Wertebereich zugeführt, während er in Figur 1 im linearen Wertebereich arbeitet. Einer Multiplikation im linearen Wertebereich entspricht eine Addition im logarithmischen Wertebereich. Deshalb ist nach Fortlassen des Delogarithmierers in Figur 3 an die Stelle des Meßpfadmultiplizierers MM ein Meßpfadaddierer MA getreten. Um dieselbe Wirkung wie in Figur 1 zu erzielen, ist in Figur 3 zusätzlich zwischen das Filter FM und den Meßpfadaddierer MA ein Vorlogarithmierer VL geschaltet, und vor den Addierer A1 ist ein Delogarithmierer D1 geschaltet. Anstelle der multiplikativen Abgleichkonstante km wird nun anders als in Figur 1 einem Abgleichaddierer Am der Wert k'm = log km zugeführt, was im logarithmischen Wertebereich geschieht und daher der Multiplikation im linearen Wertebereich in Figur 1 (mit dem Abgleichmultiplizierer MM) entspricht. Der in Figur 1 vor dem Addierer A1 eingesetzte Betragsbilder B ist nun vor dem Vorlogarithmierer VL angeordnet, um dieselbe Funktion der Schaltungsanordnung sicherzustellen.

Eine weitere Variationsmöglichkeit zeigt Figur 4. Hier ist der im linearen Wertebereich arbeitende Signalpfadmultiplizierer SM aus den Figuren 1 und 3 ersetzt durch einen im logarithmischen Wertebereich arbeitenden Signalpfadaddierer SA, dem als Stellgröße die im logarithmischen Wertebereich liegende Stellgröße SG1 zugeführt ist. Dem Signalpfadaddierer ist wiederum ein Logarithmierer LS vor- bzw. Delogarithmierer D3 nachgeschaltet, und die Multiplikation mit ks in Figur 1 ist in Figur 4 in den logarithmischen Bereich - dort als Addition mit Hilfe des Abgleichaddierers As - hineingeschoben.

Abgesehen von allen Variationsmöglichkeiten besteht das Gemeinsame darin, daß in den Signalpfadknoten SM der Meßpfad M mündet, worin die Regelstrecke R mit der Gegenkopplungsrückführung G vorgesehen ist, die in den Meßsignalpfadknoten MM mündet. Im Regelkreis ist in Signalflußrichtung zwischen dem Logarithmierer LM und dem Delogarithmierer DG, D1 der Integrierer Sz-T'-Rf-A3 vorgesehen, und die Gewichtung der vom Integrierer ausgehenden Signale ist für die Zuführung zum Meßpfadknoten MM und zum Signalpfadknoten SM unterschiedlich.

|1| Schröder, E.; Wermuth, J.: Ein neues Kompandersystem - Grundlagen und Einsatzmöglichkeiten.
Fernseh- und Kino-Technik, Band 30 (1976), Nr. 12, Seiten 424 - 429.
|2| Wermuth, J.: Kompandersystem "telcom C4".
Fernseh- und Kino-Technik, 34. Jahrgang, Nr. 3/80, Seiten 91 - 94.
|3| Wermuth, J.; Schneider, W.: Design and Application of a New Compact Compander Card.
Audio Engineering Society (AES) Preprint of the 79th Convention 1985, October 12-16, New York.
|4| Göckler, H.: Einstellbare Digitalfilter für die Tontechnik.
ntz Archiv, Band 7 (1985), Heft 3, Seiten 47-57.
|5| EP-A-118 144

**Patentansprüche**

1. Verfahren zur Verarbeitung von Signalen, die von einem Speichermedium mit komprimiert aufgezeichneten Analogsignalen abgetastet werden, um entweder digital oder analog übertragen, weiterbearbeitet und/oder wieder aufgezeichnet zu werden, dadurch gekennzeichnet, daß die Signale zunächst analog/digital gewandelt und erst dann digital expandiert werden.

2. Anordnung zur Verarbeitung von Signalen, mit einer Abtasteinrichtung für ein Speichermedium (Spm), auf dem Analogsignale komprimiert aufgezeichnet sind, und mit einer nachgeschalteten analogen oder digitalen Übertragungs-, Weiterbearbeitungs- und/oder Aufzeichnungseinrichtung, dadurch gekennzeichnet, daß für die Verarbeitung zwischen die Abtasteinrichtung (Abt) einerseits und die Übertragungs-, Weiterbearbeitungs- bzw. Aufzeichnungseinrichtung andererseits die Reihenschaltung eines A/D-Wandlers und eines nachgeschalteten digitalen Expanders (Ex) geschaltet ist.

3. Anordnung nach Anspruch 2, dadurch gekennzeichnet, daß der digitale Expander (Ex) folgende Merkmale aufweist:

a In einem Signalpfad (S) zwischen Eingang (EI) und Ausgang (AI) ist ein Signalpfadknoten (SM, SA) vorgesehen,

b vor dem Signalpfadknoten (SM, SA) ist eine Abzweigung (Ab) zu einem Meßpfad (M) vorgesehen, der in den Signalpfadknoten (SM, SA) mündet,

c im Meßpfad (M) ist eine Regelstrecke (R) eines Regelkreises vorgesehen, dessen Gegenkopplungsrückführung (G) in einen Meßpfadknoten (MM, MA) mündet,

d die Anordnung ist in Digitaltechnik aufgebaut,

e im Regelkreis ist in Signalflußrichtung zwischen einem Logarithmierer (LM) und einem Delogarithmierer (DG, D1) ein Integrierer (Sz-T'-Rf-A3) vorgesehen,

f die Gewichtung der vom Integrierer ausgehenden Signale ist für die Zuführung zum Meßpfadknoten (MM) und zum Signalpfadknoten (SM) unterschiedlich.

4. Anordnung nach Anspruch 3, gekennzeichnet durch folgende Merkmale:

g1 der Meßpfadknoten ist ein Meßpfadaddierer (MA) mit vorgeschaltetem Logarithmierer (VL), und in der Regelstrecke ist in Signalflußrichtung zunächst ein Delogarithmierer (D1) und später ein Logarithmierer (LM) vorgesehen (Figur 3) oder

g2 der Meßpfadknoten ist ein Meßpfadmultiplizierer (MM), wobei die Regelstrecke (R) einen Logarithmierer (LM) und die Gegenkopplungsrückführung (G) einen Delogarithmierer (DG) aufweist (Figur 1),

h1 der Signalpfadknoten ist ein Signalpfadaddierer (SA), wobei innerhalb des Signalpfades (S) dem Signalpfadknoten ein Logarithmierer (LS) vor- und ein Delogarithmierer (D3) nachgeschaltet ist (Figur 4) oder

h2 der Signalpfadknoten ist ein Signalpfadmultiplizierer (SM), und zwischen Regelkreis und Signalpfadknoten ist ein Delogarithmierer (D2) in den Meßpfad (M) geschaltet (Figur 1 und 3),

i für Ausgangssignale der Regelstrecke (R), die durch vorangegangene Logarithmierung im logarithmischen Wertebereich vorliegen, sind für die Zuführung zum Ausgang (Al) bzw. Meßpfadknoten (MA, MM) abgesehen von unterschiedlichem Vorzeichen auch unterschiedlich gewichtende Gewichtungsmittel (M1, M1′, M2, M2′) vorgesehen.

5. Anordnung nach Anspruch 4, dadurch gekennzeichnet, daß die Gewichtungsmittel (M1, M1′, M2, M2′) zwischen dem Ausgang der Regelstrecke (R) einerseits und andererseits im Regelkreis und/oder bis zum Ausgang (Al) der Anordnung jeweils vor dem in Signalflußrichtung nächsten Delogarithmierer (DG, D1, D2, D3) angeordnet sind, wobei sie so ausgelegt sind, daß diejenigen Signale, welche letztlich zum Delogarithmierer (DG, D1) im Regelkreis fließen, doppelt so hoch gewichtet sind ((n-m)-/m = 1/2 mit m = 2 und n = 3), wie die dem anderen (D2, D3) der beiden Delogarithmierer zugeführten Signale.

6. Anordnung nach Anspruch 4, dadurch gekennzeichnet, daß wenigstens einer der darin vorgesehenen Logarithmierer (LM, VL, LS) und/oder Delogarithmierer (DG, D2, D1, D3) als Rechenschaltung ausgebildet ist, welche ihre Ausgangssignale mittels einer Reihenentwicklung in Abhängigkeit von ihren jeweiligen Eingangssignalen berechnet.

7. Anordnung nach Anspruch 4, dadurch gekennzeichnet, daß wenigstens einer der darin vorgesehenen Logarithmierer (LM, VL, LS) und/oder Delogarithmierer (DG, D2, D1, D3) Mittel zum Rückgreifen auf einen Speicher aufweist zum Auslesen darin gespeicherter Werte als Ausgangssignale nach Zuordnung zu jeweiligen Eingangssignalen.

8. Anordnung nach einem der Ansprüche 2 bis 7, dadurch gekennzeichnet, daß in der Regelstrecke (R) nach einem Logarithmierer (LM) ein digitales, nichtlineares Übertragungsglied (NLV) vorgesehen ist, welches das dynamische Verhalten bei schnellen Pegelanhebungen am Eingang (El) bestimmt.

9. Anordnung nach Anspruch 8, dadurch gekennzeichnet, daß das Übertragungsglied (NLV) vorgesehen ist zur Errechnung seiner Ausgangssignale aus seinen Eingangssignalen aufgrund einer vorgegebenen Funktion.

10. Anordnung nach Anspruch 8, dadurch gekennzeichnet, daß das Übertragungsglied (NLV) Mittel zum Rückgreifen auf einen Speicher aufweist zum Auslesen darin gespeicherter Werte als Ausgangssignale nach Zuordnung zu jeweiligen Eingangssignalen.

11. Anordnung nach Anspruch 6 und 9 oder nach Anspruch 7 und 10, dadurch gekennzeichnet, daß das Übertragungsglied (NLV) mit dem ihm vorgeschalteten Logarithmierer (LM) zu einer einzigen Schaltung (S4) zusammengefaßt ist.

12. Anordnung nach einem der Ansprüche 2 bis 11, dadurch gekennzeichnet, daß die Abtastfrequenz ($f'_A$) im Regelkreis gleich oder größer ist als die Abtastfrequenz ($f_A$) im Signalpfad (S).

13. Anordnung nach einem der Ansprüche 2 bis 12, dadurch gekennzeichnet, daß dem Signalpfadknoten (SM, SA) und/oder dem Meßpfadknoten (MM, MA) ein Filter (FS, FM) vorgeschaltet ist.

14. Anordnung nach Anspruch 13, dadurch gekennzeichnet, daß das Filter (FS, FM) aus kaskadierten oder parallelgeschalteten Teilfiltern besteht.

15. Anordnung nach Anspruch 14, dadurch gekennzeichnet, daß das Filter (FS, FM) ein Rekursivfilter mit kanonischer Struktur ist.

16. Anordnung nach Anspruch 14, dadurch gekennzeichnet, daß das Filter ein Rekursivfilter mit Zustandsraumstruktur ist.

17. Anordnung nach einem der Ansprüche 2 bis 16, dadurch gekennzeichnet, daß vor dem Logarithmierer (LM) der Regelstrecke (R) ein Abgleichmultiplizierer (MM) oder dem Delogarithmierer (D1) der Regelstrecke (R) ein Abgleichaddierer (Am) vorgesehen ist.

18. Anordnung nach Anspruch 16 und 17, dadurch gekennzeichnet, daß der Abgleichmultiplizierer (Mm) in das Zustandsraumstrukturfilter (FM) im Meßpfad (M) integriert (S3) ist.

19. Anordnung nach einem der Ansprüche 3 bis 18, dadurch gekennzeichnet, daß am Ausgang des Signalpfadmultiplizierers (SM) oder am Ausgang des Meßpfades (M), wo jeweils Signale im linearen Wertebereich vorliegen, ein Abgleichmultiplizierer (Ms, Ms1) vorgesehen ist.

20. Anordnung nach einem der Ansprüche 2 bis 18, dadurch gekennzeichnet, daß am Ausgang des Signalpfadaddierers (SA) oder am Ausgang des Meßpfades (M), wo jeweils Signale im logarithmischen Wertebereich vorliegen, ein Abgleichaddierer (As) vorgesehen ist (Fig. 4).

21. Anordnung nach einem der Ansprüche 3 bis 20, dadurch gekennzeichnet, daß in der Gegenkopplungsrückführung (G) eine Schaltung (S1) vorgesehen ist, die einen Delogarithmierer (DG) mit einem eingangsseitigen Vorzeichenumkehrer und/oder Gewichtungsmittel (M1) zusammenfaßt (Fig. 1).

22. Anordnung nach einem der Ansprüche 2 bis 21, dadurch gekennzeichnet, daß ein Gewichtungsmittel (M2, M2') für Signale im logarithmischen Wertebereich im Meßpfad (M) hinter dem Regelkreis mit einem nachfolgenden Delogarithmierer (D2) zusammengefaßt (S2) ist.

23. Anordnung nach einem der Ansprüche 2 bis 22, dadurch gekennzeichnet, daß in der Regelstrecke (R) zwischen dem Meßpfadmultiplizierer (MM) und einem Addierer (A1) im linearen Wertebereich ein Betragsbilder (B) vorgesehen ist (Fig. 1).

24. Anordnung nach Anspruch 13, dadurch gekennzeichnet, daß zwischen dem Filter (FM) im Meßpfad (M) und dem Meßpfadmultiplizierer (MM) ein Betragsbilder (B) vorgesehen ist.

25. Anordnung nach Anspruch 13, dadurch gekennzeichnet, daß zwischen dem Filter (FM) im Meßpfad (M) und einem Logarithmierer (VL) vor dem Meßpfadaddierer (MA) ein Betragsbilder (B) vorgesehen ist (Fig. 3).

26. Anordnung nach einem der Ansprüche 2 bis 25, dadurch gekennzeichnet, daß in der Regelstrecke (R) ein Amplitudenbegrenzer (SI) vorgesehen ist.

27. Anordnung nach einem der Ansprüche 2 bis 26, dadurch gekennzeichnet, daß die Regelstrecke (R) mit einem Integrierer (A3-Sz-T'-Rf) abschließt.

28. Anordnung nach Anspruch 27, dadurch gekennzeichnet, daß der Integrierer in einer Integrierer-Regelstrecke einen Amplitudenbegrenzer (Sz) und in einer Rückführung (Rf) ein Verzögerungsglied (T') aufweist.

29. Anordnung nach Anspruch 27, dadurch gekennzeichnet, daß dem Integrierer im Meßpfad (M) ein Addierer (A2) vorgeschaltet ist zur Addition einer Größe (Io), welche das dynamische Verhalten bei Pegelabsenkungen am Eingang

(EI) bestimmt.

30. Anordnung nach einem der Ansprüche 2 bis 29, dadurch gekennzeichnet, daß die Anordnung für ein Teilfrequenzband eines Frequenzbandes dimensioniert ist und mehrere (L), das ganze Frequenzband abdeckende Anordnungen eingangsseitig parallelgeschaltet und ausgangsseitig über wenigstens einen Addierer (Ad) zusammengeschaltet sind.

**Claims**

1. Method of processing signals which are read from a storage medium with analogue signals recorded in a compressed manner in order to be transmitted, further processed and/or recorded again in an either digital or analogue manner, characterised in that the signals are firstly digitised and then expanded digitally.

2. Arrangement for processing signals, having a reading device for a storage medium (Spm), on which medium analogue signals are recorded in a compressed manner, and having an analogue or digital transmission, further processing and/or recording device connected downstream, characterised in that the series arrangement of an analogue/digital convertor and a digital expander (Ex) connected downstream is connected for processing between the reading device (Abt) on the one hand and the transmission, further processing and/or recording device on the other.

3. Arrangement according to Claim 2, characterised in that the digital expander (Ex) has the following features:
   a a signal path node (SM, SA) is provided in a signal path (S) between the input (EI) and the output (AI);
   b a branch (Ab) to a measuring path (M) which leads into the signal path node (SM, SA) is provided in front of the signal path node (SM, SA);
   c a control section (R) of a control circuit, of which the reverse feedback path (G) leads into a measuring path node (MM, MA), is provided in the measuring path (M);
   d the arrangement is constructed with digital technology;
   e an integrator (Sz-T'-Rf-A3) is provided in the control circuit in the direction in which the signal flows between a logarithmiser (LM) and a delogarithmiser (DG, D1);
   f the weighting of the signals emitted by the integrator differs for the delivery to the measuring path node (MM) and to the signal path node (SM).

4. Arrangement according to Claim 3, characterised by the following features:

g1 the measuring path node is a measuring path adder (MA) with a logarithmiser (VL) which is connected upstream, and, in the control section in the direction of flow of the signals, firstly a delogarithmiser (D1) is provided and subsequently a logarithmiser (LM) (Figure 3); or

g2 the measuring path node is a measuring path multiplier (MM), the control section (R) comprising a logarithmiser (LM) and the reverse feedback path (G) comprising a delogarithmiser (DG) (Figure 1);

h1 the signal path node is a signal path adder (SA), a logarithmiser (LS) being provided upstream of the signal path node and a delogarithmiser (D3) being provided downstream of the signal path node within the signal path (S) (Figure 4); or

h2 the signal path node is a signal path multiplier (SM), and a delogarithmiser (D2) is connected between the control circuit and signal path node in the measuring path (M) (Figures 1 and 3);

i differently weighted weighting means (M1, M1', M2, M2') are also provided for output signals of the control section (R), which signals are in the logarithmic range of values as a result of a preceding logarithmation, for delivery to the output (AI) or measuring path node (MA, MM) irrespective of the different polarity.

5. Arrangement according to Claim 4, characterised in that the weighting means (M1, M1', M2, M2') are disposed between the output of the control section (R) on the one hand and on the other in the control circuit and/or as far as the output (AI) of the arrangement in each case in front of the next delogarithmiser (DG, D1, D2, D3) in the signal flow direction, the weighting means being designed such that the signals which flow last to the delogarithmiser (DG, D1) in the control circuit are weighted twice as much ($(n-m)/m = 1/2$ when $m = 2$ and $n = 3$) as the signals delivered to the other (D2, D3) of the two delogarithmisers.

6. Arrangement according to Claim 4, characterised in that at least one of the logarithmisers (LM, VL, LS) and/or delogarithmisers (DG, D2, D1, D3) provided therein is in the form of a computational circuit which calculates its output signals by means of a series expansion in dependence upon its input signals in each case.

7. Arrangement according to Claim 4, characterised in that at least one of the logarithmisers (LM, VL, LS) and/or delogarithmisers (DG, D2, D1, D3) provided therein comprises means for referring back to a memory for the read out of values stored therein as output signals after allocation to the respective input signals.

8. Arrangement according to any one of Claims 2 to 7, characterised in that a digital, non-linear transmission device (NLV), which determines the dynamic behaviour in the case of rapid level increases at the input (EL), is provided in the control section (R) after a logarithmiser (LM).

9. Arrangement according to Claim 8, characterised in that the transmission device (NLV) is provided for calculating its output signals from its input signals on the basis of a predetermined function.

10. Arrangement according to Claim 8, characterised in that the transmission device (NLV) comprises means for referring back to a memory for reading out values stored therein as output signals after allocation to the respective input signals.

11. Arrangement according to Claim 6 and Claim 9 or Claim 7 and Claim 10, characterised in that the transmission device (NLV) is combined with the logarithimiser (LM) connected upstream thereof to form a single circuit (S4).

12. Arrangement according to any one of Claims 2 to 11, characterised in that the sampling frequency ($f'_A$) in the control circuit is greater than or equal to the sampling frequency ($f_A$) in the signal path (S).

13. Arrangement according to any one of Claims 2 to 12, characterised in that a filter (FS, FM) is connected upstream of the signal path node (SM, SA) and/or the measuring path node (MM, MA).

14. Arrangement according to Claim 13, characterised in that the filter (FS, FM) consists of cascaded partial filters or partial filters which are connected in parallel.

15. Arrangement according to Claim 14, characterised in that the filter (FS, FM) is a recursive filter with a canonical structure.

16. Arrangement according to Claim 14, characterised in that the filter is a recursive filter
having a status space structure.

17. Arrangement according to any one of Claims 2
to 16, characterised in that a balancing multiplier (Mm) is provided in front of the logarithmiser (LM) of the control section (R), or a
balancing adder (Am) is provided in front of
the delogarithmiser (D1) of the control section
(R).

18. Arrangement according to Claims 16 and 17,
characterised in that the balancing multiplier
(Mm) is integrated in the status space structure
filter (FM) in the measuring path (M) (S3).

19. Arrangement according to any one of Claims 3
to 18, characterised in that a balancing multiplier (Ms, Ms1) is provided at the output of the
signal path multiplier (SM) or at the output of
the measuring path (M) where there are signals in the linear range of values in each case.

20. Arrangement according to any one of Claims 2
to 18, characterised in that a balancing adder
(As) is provided at the output of the signal path
adder (SA) or at the output of the measuring
path (M) where there are signals in the logarithmic range of values (Figure 4).

21. Arrangement according to any one of Claims 3
to 20, characterised in that a circuit (S1) which
combines a delogarithmiser (DG) with a sign
reversing device on the input side and/or
weighting means (M1) is provided in the reverse feedback path (G) (Figure 1).

22. Arrangement according to any one of Claims 2
to 21, characterised in that a weighting means
(M2, M2') for signals in the logarithmic range
of values are combined with a subsequent
delogarithmiser (D2) in the measuring path
(M) behind the control circuit (S2).

23. Arrangement according to any one of Claims 2
to 22, characterised in that a magnitude former
(B) is provided in the control section (R) between the measuring path multiplier (MM) and
an adder (A1) in the linear range of values
(Figure 1).

24. Arrangement according to Claim 13, characterised in that an a magnitude former (B) is
provided between the filter (FM) in the measuring path (M) and the measuring path multiplier
(MM).

25. Arrangement according to Claim 13, characterised in that a magnitude former (B) is provided between the filter (FM) in the measuring
path (M) and a logarithmiser (VL) in front of the
measuring path adder (MA) (Figure 3).

26. Arrangement according to any one of Claims 2
to 25, characterised in that an amplitude limit-
ing device (SI) is provided in the control section (R).

27. Arrangement according to any one of Claims 2
to 26, characterised in that the control section
(R) terminates in an integrator (A3-Sz-T'-Rf).

28. Arrangement according to Claim 27, characterised in that, in an integrator-control section,
the integrator comprises an amplitude limiter
(Sz) and a delay member (T') in a feedback
path (Rf).

29. Arrangement according to Claim 27, characterised in that an adder (A2) is connected
upstream of the integrator in the measuring
path (M) in order to add a value (Io) which
determines the dynamic behaviour when the
level drops at the input (EI).

30. Arrangement according to any one of Claims 2
to 29, characterised in that the arrangement is
dimensioned for a partial frequency band of a
frequency band and a plurality (L) of arrangements covering the entire frequency band is
connected in parallel on the input side and
interconnected on the output side via at least
one adder (Ad).

**Revendications**

1. Procédé pour le traitement de signaux analogiques lus sur un support d'informations après
enregistrement avec compression pour être
ensuite transmis, de nouveau traités et/ou de
nouveau enregistrés soit sous forme numérique, soit sous forme analogique, caractérisé en
ce que les signaux sont d'abord convertis
d'analogique en numérique et, seulement
après, expansés numériquement.

2. Montage pour le traitement de signaux, avec
un dispositif de lecture pour un support d'informations (Spm) sur lequel des signaux analogiques sont enregistrés avec compression, et
avec un dispositif analogique ou numérique de
transmission, traitement supplémentaire et/ou
enregistrement en aval, caractérisé en ce que
pour le traitement, entre le dispositif de lecture
(Abt), d'une part, et le dispositif de transmission, traitement supplémentaire et/ou enregistrement, d'autre part, il est prévu un convertisseur analogique/numérique et un expanseur numérique (Ex) en aval montés en série.

3. Montage selon la revendication 2, caractérisé en ce que l'expanseur numérique (Ex) présente les particularités suivantes :

    a) dans un chemin de signal (S) situé entre l'entrée (EI) et la sortie (AI), il est prévu un noeud de chemin de signal (SM, SA);

    b) avant le noeud de chemin de signal (SM, SA), il est prévu une dérivation (Ab) vers un chemin de mesure (M) qui aboutit au noeud de chemin de signal (SM, SA);

    c) dans le chemin de mesure (M), il est prévu une chaîne d'asservissement (R) d'une boucle d'asservissement, dont la chaîne de contre-réaction (G) aboutit à un noeud du chemin de mesure (MM, MA);

    d) le montage est réalisé en technique numérique;

    e) dans la boucle d'asservissement, il est prévu un intégrateur (Sz-T'-Rf-A3) entre un logarithmiseur (LM) et un délogarithmiseur (DG, D1) dans le sens de circulation des signaux;

    f) la pondération des signaux de sortie de l'intégrateur est différente pour l'application au noeud du chemin de mesure (MM) et au noeud du chemin de signal (SM).

4. Montage selon la revendication 3, caractérisé en outre par les particularités suivantes :

    g1) le noeud du chemin de mesure est un additionneur de chemin de mesure (MA) précédé d'un logarithmiseur (VL) et, dans la boucle d'asservissement, dans le sens de circulation des signaux, il est prévu d'abord un délogarithmiseur (D1) et ensuite un logarithmiseur (LM) (figure 3); ou

    g2) le noeud du chemin de mesure est un multiplieur de chemin de mesure (MM), la chaîne d'asservissement (R) comportant un logarithmiseur (LM) et la chaîne de contre-réaction (G) un délogarithmiseur (DG) (figure 1);

    h1) le noeud du chemin de signal est un additionneur de chemin de signal (SA), dans le chemin de signal (S) le noeud du chemin de signal étant précédé d'un logarithmiseur (LS) et suivi d'un délogarithmiseur (D3) (figure 4); ou

    h2) le noeud du chemin de signal est un multiplieur de chemin de signal (SM) et, entre la chaîne d'asservissement et le noeud du chemin de signal, un délogarithmiseur (D2) est monté dans le chemin de signal (M) (figures 1 et 3);

    i) pour les signaux de sortie de la boucle d'asservissement (R), qui sont amenés dans le domaine logarithmique de valeurs par la logarithmisation précédente, pour l'application à la sortie (AI) et au noeud du chemin de mesure (MA, MM), respectivement, indépendamment des signes différents, il est également prévu des moyens de pondération (M1, M1', M2, M2') à pondérations différentes.

5. Montage selon la revendication 4, caractérisé en ce que les moyens de pondération (M1, M1', M2, M2') sont disposés entre la sortie de la chaîne d'asservissement (R), d'une part, et d'autre part, dans la boucle d'asservissement et/ou jusqu'à la sortie (AI) du montage, dans chaque cas avant le prochain délogarithmiseur (DG, D1, D2, D3) dans le sens de circulation du signal, lesdits moyens étant conçus de telle manière que les signaux qui arrivent en dernier au délogarithmiseur (DG, D1) dans la boucle d'asservissement sont pondérés deux fois plus fortement ($(n-m)/m = 1/2$, avec $m = 2$ et $n = 3$) que les signaux appliqués à l'autre (D2, D3) des deux délogarithmiseurs.

6. Montage selon la revendication 4, caractérisé en ce qu'au moins un des logarithmiseurs (LM, VS, LS) et/ou délogarithmiseurs (DG, D2, D1, D3) prévus dans celui-ci est réalisé sous la forme d'un circuit de calcul qui calcule ses signaux de sortie au moyen d'un développement en série en fonction de ses signaux d'entrée respectifs.

7. Montage selon la revendication 4, caractérisé en ce qu'au moins un des logarithmiseurs (LM, VL, LS) et/ou délogarithmiseurs (DG, D2, D1, D3) prévus dans celui-ci comporte des moyens pour utiliser une mémoire pour lire dans celle-ci des valeurs mémorisées comme signaux de sortie après mise en correspondance avec des signaux d'entrée respectifs.

8. Montage selon l'une des revendications 2 à 7, caractérisé en ce que dans la chaîne d'asservissement (R), après un logarithmiseur (LM), il est prévu un organe de transmission non linéaire (NLV) qui détermine le comportement dynamique lors d'augmentations rapides du niveau à l'entrée (EI).

9. Montage selon la revendication 8, caractérisé en ce que l'organe de transmission non linéaire (NLV) est prévu pour que ses signaux de sortie soient calculés à partir de ses signaux d'entrée sur la base d'une fonction donnée.

10. Montage selon la revendication 8, caractérisé en ce que l'organe de transmission non linéaire (NLV) comporte des moyens pour utiliser une mémoire pour lire dans celle-ci des valeurs mémorisées comme signaux de sortie après mise en correspondance avec des signaux d'entrée respectifs.

11. Montage selon les revendications 6 et 9 ou selon les revendications 7 et 10, caractérisé en ce que l'organe de transmission non linéaire (NLV) est groupé avec le logarithmiseur qui le précède (LM) pour former un seul et même circuit (S4).

12. Montage selon l'une des revendications 2 à 11, caractérisé en ce que la fréquence d'échantillonnage ($f'_A$) dans la boucle d'asservissement est égale ou supérieure à la fréquence d'échantillonnage ($f_A$) dans le chemin de signal (S).

13. Montage selon l'une des revendications 2 à 12, caractérisé en ce que le noeud du chemin de signal (SM, SA) et/ou le noeud du chemin de mesure (MM, MA) sont précédés d'un filtre (FS, FM).

14. Montage selon la revendication 13, caractérisé en ce que le filtre (FS, FM) est composé de filtres partiels montés en cascade ou en parallèle.

15. Montage selon la revendication 14, caractérisé en ce que le filtre (FS, FM) est un filtre récursif à structure canonique.

16. Montage selon la revendication 14, caractérisé en ce que le filtre est un filtre récursif à structure à espace d'états.

17. Montage selon l'une des revendications 2 à 16, caractérisé en ce qu'il est prévu un multiplieur d'égalisation (Mm) avant le logarithmiseur (LM) de la chaîne d'asservissement (R) ou un additionneur d'égalisation (Am) avant le délogarithmiseur (D1) de la chaîne d'asservissement (R).

18. Montage selon les revendications 16 et 17, caractérisé en ce que le multiplieur d'égalisation (Mm) est intégré (S3) au filtre à structure à espace d'états (FM) dans le chemin de mesure (M).

19. Montage selon l'une des revendications 3 à 18, caractérisé en ce qu'à la sortie du multiplieur du chemin de signal (SM) ou à la sortie du chemin de mesure (M), où dans les deux cas les signaux sont compris dans le domaine linéaire de valeurs, il est prévu un multiplieur d'égalisation (Ms, Ms1).

20. Montage selon l'une des revendications 2 à 18, caractérisé en ce qu'à la sortie de l'additionneur du chemin de signal (SA) ou à la sortie du chemin de mesure (M), où dans les deux cas les signaux sont compris dans le domaine logarithmique de valeurs, il est prévu un additionneur d'égalisation (As) (figure 4).

21. Montage selon l'une des revendications 3 à 20, caractérisé en ce que dans la chaîne de retour de contre-réaction (G), il est prévu un circuit (S1) qui groupe un délogarithmiseur (DG) et un inverseur de signe et/ou des moyens de pondération (M1) du côté de l'entrée (figure 1).

22. Montage selon l'une des revendications 2 à 21, caractérisé en ce que des moyens de pondération (M2, M2') pour des signaux compris dans un domaine logarithmique de valeurs sont groupés (S2) avec un délogarithmiseur (D2) qui le suit après la boucle d'asservissement dans le chemin de mesure (M).

23. Montage selon l'une des revendications 2 à 32, caractérisé en ce que dans la chaîne d'asservissement (R), entre le multiplieur du chemin de mesure (MM) et un additionneur (A1), il est prévu un organe de formation de montant (B) dans le domaine linaire de valeurs (figure 1).

24. Montage selon la revendication 13, caractérisé en ce qu'entre le filtre (FM) dans le chemin de mesure (M) et le multiplieur du chemin de mesure (MM), il est prévu un organe de formation de montant (B).

25. Montage selon la revendication 13, caractérisé en ce qu'entre le filtre (FM) dans le chemin de mesure (M) et un logarithmiseur (VL), avant l'additionneur du chemin de mesure (MA), il est prévu un organe de formation de montant (B) (figure 3).

26. Montage selon l'une des revendications 2 à 25, caractérisé en ce que dans la chaîne d'asservissement (R), il est prévu un limiteur d'amplitude (SL).

**27.** Montage selon l'une des revendications 2 à 26, caractérisé en ce que la chaîne d'asservissement (R) se termine par un intégrateur (A3-Sz-T'-Rf).

**28.** Montage selon la revendication 27, caractérisé en ce que l'intégrateur comporte un limiteur d'amplitude (Sz) dans une chaîne d'asservissement d'intégrateur et un organe de retard (T') dans une chaîne de rétroaction (Rf).

**29.** Montage selon la revendication 27, caractérisé en ce que l'intégrateur prévu dans le chemin de mesure (M) est précédé d'un additionneur (A2) pour l'addition d'une grandeur (Io) qui détermine le comportement dynamique lors de diminutions du niveau à l'entrée (EI).

**30.** Montage selon l'une des revendications 2 à 29, caractérisé en ce que le montage est dimensionné pour une bande de fréquences partielle d'une bande de fréquences et plusieurs (L) montages couvrant la gamme de fréquences complète sont montés en parallèle du côté de l'entrée et réunis par l'intermédiaire d'au moins un additionneur (Ad) du côté de la sortie.

FIG. 1

FIG. 2

FIG. 3

FIG. 4

EP 0 310 769 B1

FIG. 5